**Europäisches Patentamt**

**European Patent Office**

**Office européen des brevets**

(19)

(11)  **EP 1 674 421 A2**

(12)  **EUROPEAN PATENT APPLICATION**

(43) Date of publication:
28.06.2006  Bulletin 2006/26

(51) Int Cl.:
*B66C 9/16* (2006.01)  *H05K 13/08* (2006.01)

(21) Application number: 05077487.6

(22) Date of filing: 01.11.2005

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **22.12.2004  NL 1027851**

(71) Applicant: **Assembléon N.V.**
**5503 LA  Veldhoven (NL)**

(72) Inventor: **Van der Burg, Richard Adrianus Johannes**
**5646 HS Eindhoven (NL)**

(74) Representative: **Veldman-Dijkers, Cornelia G. C. et al**
**Algemeen Octrooi- en Merkenbureau**
**P.O. Box 645**
**5600 AP Eindhoven (NL)**

(54) **Method for controlling a dynamic system as well as a device suitable for carrying out such a method**

(57)  A method for controlling a dynamic system comprising two guides extending parallel to each other and a beam extending transversely to said guides, which beam is movable over said guides, with a slide being movable over said beam, characterized in that

- a first difference is determined between the desired position and the actual position of the beam on the first guide,
- a second difference is determined between the desired position and the actual position of the beam on the second guide,

- the position difference between the desired position and the actual position of a specific point on the beam is determined on the basis of said first and second differences,
- a variation between said first difference and said second difference is furthermore determined on the basis of said first and second differences,
- after which the force and the torque to be exerted on the beam are determined at least in dependence on said position difference, said variation and the position of the slide relative to the centre of mass of the beam.

FIG.1

**Description**

The invention relates to a method for controlling a dynamic system comprising two guides extending parallel to each other and a beam extending transversely to said guides, which beam is movable over said guides, with a slide being movable over said beam.

The invention also relates to a device suitable for carrying out such a method.

The control of such a dynamic system is known, for example from US patent US-A-6,163,116. The advantage of moving a beam over two guides extending parallel to each other is that a higher degree of stability can be obtained in this manner in comparison with situation in which the beam is moved over only one guide. Such a relatively high degree of stability is desirable in component placement machines, for example, in which the slide that is movable over the beam is provided with a nozzle for picking up components and subsequently placing the picked-up component at the desired position on, for example, a printed circuit board.

As already indicated in the aforesaid US patent, a drawback of the use of guides extending parallel to each other and motors associated with said guides is that the motor controllers influence each other.

To obviate this problem, the method according to the aforesaid US patent proposes to use a new coordinate system with two decoupled axes, being a linear axis and a rotary axis.

A drawback of said method is that it relatively complex control loops are required. In addition, it leads to virtual coordinates. The rotation is not directly available as a degree of freedom in a device and it is certainly not controlled.

The object of the invention is to provide a method by means of which the movement of the beam over the guides can be controlled in a relatively simple manner, whilst the controllers hardly influence one another.

This object is accomplished with the method according to the invention in that a first difference is determined between the desired position and the actual position of the beam on the first guide, a second difference is determined between the desired position and the actual position of the beam on the second guide, the position difference between the desired position and the actual position of a specific point on the beam is determined on the basis of said first and second differences, a variation between said first difference and said second difference is furthermore determined on the basis of said first and second differences, after which the force and the torque to be exerted on the beam are determined at least in dependence on said position difference, said variation and the position of the slide relative to the centre of mass of the beam.

It has been found that the force and the torque to be exerted on the beam can be determined in a simple manner on the basis of the position difference and the variation at a specific point, for example the centre of mass of the beam or the position of the beam at the location of the slide. The force and the torque to be exerted on the beam can easily be converted into forces to be exerted on the slide at the location of the first and the second guide.

One embodiment of the method according to the invention is characterized in that the position difference is corrected in dependence on the position of the slide relative to said specific point on the beam, after which the corrected position difference is supplied to a first controller for determining the force to be exerted on the beam.

In this way the force to be exerted on the beam is determined in part in dependence on the position of the slide relative to the beam. The position of the centre of mass of the beam and the slide present thereon will change as a result of the movement of the slide over said beam. The force to be exerted on the slide can be determined with even greater precision by taking this into account.

Another embodiment of the method according to the invention is characterized in that the variation is supplied to a second controller for determining a torque, which torque is corrected in dependence on the position of the slide relative to the centre of mass of the beam, which corrected torque is exerted on the slide.

Since a change in the position of the centre of mass of the beam and the slide present thereon is taken into account in the determination of the torque, the torque to be exerted on the slide can be determined with greater precision.

Yet another embodiment of the method according to the invention is characterized in that the forces to be exerted on the slide at the location of the first and the second guide are determined in dependence on the force or torque to be exerted on the slide.

In this way it will be relatively easy to subsequently control the motors to drive the beam over the guides.

Yet another embodiment of the method according to the invention is characterized in that the correction of the position difference and the torque respectively takes place in dependence on the difference between the position of the centre of mass of the beam with the slide present thereon and the position the centre of mass of the beam.

In this way the actual position of the centre of mass of the beam in combination with the slide is taken into account.

Yet another embodiment of the method according to the invention is characterized in that the correction of the position difference and the torque respectively takes place in dependence on the difference between the position of the centre of mass of the slide and the position of the centre of mass of the beam.

In this way a change in the position of the centre of mass of the slide is taken into account. The centre of mass of the beam will only shift in a direction parallel to the guides. The position of the centre of mass will remain unchanged in the direction parallel to the beam.

The invention also relates to a device suitable for carrying out such a method.

To that end, the device according to the invention comprises two guides extending parallel to each other and a beam extending transversely to said guides, which beam is movable over said guides, with a slide being movable over said beam, wherein means are provided for determining a first difference between the desired position and the actual position of the beam on the first guide, means are provided for determining a second difference between the desired position and the actual position of the beam on the second guide, means are provided for determining a position difference between the desired position and the actual position of a specific point on the beam on the basis of said first and second differences, means are provided for determining a variation between said first difference and said second difference on the basis of said first and second differences, and means are provided for determining the force and the torque to be exerted on the beam in dependence at least on said position difference, said variation and the position of the slide relative to the centre of mass of the beam, as well as means for exerting the force and the torque as determined on the beam.

Using such a device it is relatively easy to move a slide to any desired position with a high degree of precision.

The invention will now be explained in more detail with reference to the drawings, in which:

Figure 1 is a schematic top plan view of a dynamic system according to the invention;
Figure 2 is a schematic representation of a control circuit for the dynamic system that is shown in figure 1.

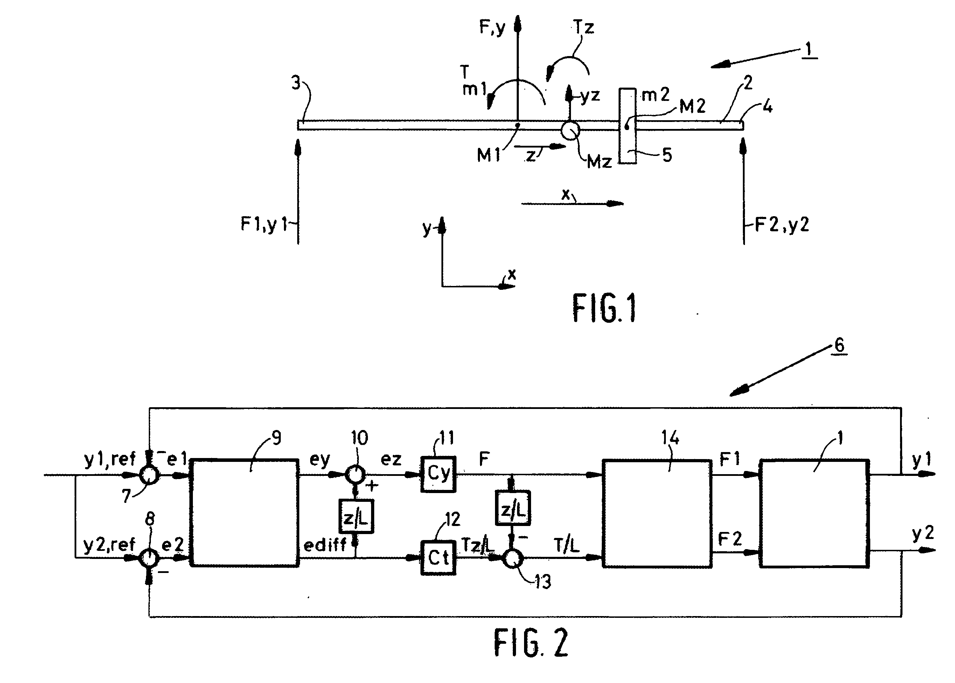

Figure 1 shows a dynamic system 1, which comprises a beam 2 that extends in the X-direction. The beam 2 is movably supported with its ends 3, 4 on parallel guides (not shown) extending in the Y-direction.

A slide 5 is movably supported on said beam 2.

The movement of the beam 2 over the guides and of the slide 5 over the beam 2 is effected by means of motors.

A force F1 is exerted on the first end 3 by means of motors that co-act with the guides, as a result of which the first end 3 is moved to a position Y1.

In a similar manner a force F2 is exerted on the second end 4, as a result of which the second end is moved to a position Y2. A force is exerted on the slide 5, as a result of which the slide 5 is moved to a position X.

The force F that is in total exerted on the beam 2 and the slide 5 in the Y-direction is the sum of the forces F1 and F2.

$$F1 + F2 = F \qquad\qquad (1)$$

The movement Y of the centre of the beam 2 equals the average of the movements Y1 and Y2.

The beam 2 has a mass m1 whose centre of mass M1 is located in the centre of the beam 2. The slide 5 has a mass m2 whose centre of mass M2 is located in the centre of the slide 5. The centre of mass Mz of the beam 2 in combination with the slide 5 will be located between the centres of mass M1, M2 of the beam 2 and the slide 5, respectively. Said centre of mass Mz is spaced from the centre M1 of the beam 2 by a distance z.

The distance z depends on the masses m1, m2; the distance x can be determined as follows.

$$z = \frac{m2}{(m1 + m2)} \cdot x \qquad\qquad (2)$$

The movement yz of the centre of mass Mz in the Y-direction depends both on the movement y1 and on the movement y2. The actual positions y1, y2 of the ends 3, 4 of the beam 2 are sensed by means of sensors.

Consequently, the length of the beam 2 is 2L. Consequently, the torque Tz that is exerted on the beam 2 in the centre of mass Mz is:

$$(F2 - F1) \cdot L - z \cdot (F1 + F2) = T - F \cdot z = Tz \qquad\qquad (3)$$

Figure 2 shows a control circuit for carrying out the method according to the invention, which control circuit is integrated in a control system for controlling the motors for moving the ends 3, 4 of the beam 2 as well as the slide 5.

The desired positions y1,ref and y2,ref of the first and the second end 3, 4 of the beam 2 are supplied to the control circuit 6. The subtracter 7 determines the first difference e1 between the desired position y1,ref and the actual position y1 of the first end 3 of the beam 2. In a similar manner the subtracter 8 determines the second difference e2 between the desired position y2,ref and the actual position y2 of the second end 4 of the beam 2.

The two differences e1, e2 are supplied to a processing unit 9, in which the differences e1, e2 are converted in accordance with the formula below into a position difference ey that indicates the difference between the actual position and the desired position of the centre M1 of the beam 2 and the actual position of the centre M1 of the beam 2.

$$\begin{vmatrix} ey \\ ediff \end{vmatrix} = \begin{vmatrix} 0,5 & 0,5 \\ -0,5 & 0,5 \end{vmatrix} \cdot \begin{vmatrix} e1 \\ e2 \end{vmatrix} \qquad (4)$$

Furthermore, the variation ediff is determined by means of the processing unit 9. The variation ediff will be zero if the first difference e1 equals the second difference e2.

The variation ediff is subsequently multiplied by Z/L and supplied to an adder 10, in which it is added to the position difference ey. This gives a value ez, which indicates a value for the difference between the desired position and the actual position of the centre of mass Mz in the Y-direction. The value ez is subsequently supplied to a first controller 11, which may comprise a PID-controller, for example, supplemented with certain filters, if desired.

The controller 11 is used for determining the force F that is to be exerted on the beam 2.

The variation ediff is supplied to a second controller 12, which may have the same structure as the controller 11, at the same time as the value ez is supplied to the controller 11.

Using the controller 12, a force Tz/L is determined from the variation ediff, which force is a measure of the torque to be exerted on the beam 2.

In the subtracter 13, a part z/L of the force F as determined by means of the controller 11 is subtracted from the force Tz/L. This gives a force T/L, which force is a measure of a torque to be exerted on the beam 2.

Both the force F determined by means of the controller 11 and the force T/L are supplied to the processing unit 14, in which the forces F1, F2 to be exerted on the ends 3, 4 of the slide 2 are determined by means of the formula below.

$$\begin{vmatrix} F1 \\ F2 \end{vmatrix} = \begin{vmatrix} 0,5 & -0,5 \\ 0,5 & 0,5 \end{vmatrix} \cdot \begin{vmatrix} F \\ T/L \end{vmatrix} \qquad (5)$$

Said forces F1, F2 are then transmitted to the ends 3, 4 by means of the motors, causing the ends 3, 4 to move over the guides in question and subsequently take up a position y1, y2. Said positions y1, y2, which can be sensed by means of sensors, are subsequently fed back to the subtracters 7, 8.

Since the controllers 11, 12 function independently of each other, they will not influence each other. It is also possible to multiply ediff by x/L rather than by z/L, resulting in a value ex, which will subsequently be supplied to the controller 11. The value ex is a measure of the difference of the centre of mass m2 of the slide 5 in the Y-direction.

The forces are preferably applied in the centre of mass.

It is possible to configure the control circuit 6 as an MIMO controller (Multi Input Multi Output), wherein furthermore a minimal interaction takes place between the two control loops for the two Y-drive units.

The method and the device according to the invention are suitable for various applications in which a slide 5 is to be precisely positioned, such as a component placement machine.

**Claims**

1. A method for controlling a dynamic system comprising two guides extending parallel to each other and a beam extending transversely to said guides, which beam is movable over said guides, with a slide being movable over said beam,
   **characterized in that**

   - a first difference is determined between the desired position and the actual position of the beam on the first guide,
   - a second difference is determined between the desired position and the actual position of the beam on the second guide,
   - the position difference between the desired position and the actual position of a specific point on the beam is determined on the basis of said first and second differences,

- a variation between said first difference and said second difference is furthermore determined on the basis of said first and second differences,

- after which the force and the torque to be exerted on the beam are determined at least in dependence on said position difference, said variation and the position of the slide relative to the centre of mass of the beam.

2. A method according to claim 1, **characterized in that** the position difference is corrected in dependence on the position of the slide relative to said specific point on the beam, after which the corrected position difference is supplied to a first controller for determining the force to be exerted on the beam.

3. A method according to claim 1 or 2, **characterized in that** the variation is supplied to a second controller for determining a torque, which torque is corrected in dependence on the position of the slide relative to the centre of mass of the beam, which corrected torque is exerted on the slide.

4. A method according to any one of the preceding claims, **characterized in that** the forces to be exerted on the slide at the location of the first and the second guide are determined in dependence on the force or torque to be exerted on the slide.

5. A method according to any one of the preceding claims, **characterized in that** the correction of the position difference and the torque respectively takes place in dependence on the difference between the position of the centre of mass of the beam with the slide present thereon and the position of the centre of mass of the beam.

6. A method according to any one of the preceding claims, **characterized in that** the correction of the position difference and the torque respectively takes place in dependence on the difference between the position of the centre of mass of the slide and the position of the centre of mass of the beam.

7. A device suitable for carrying out a method according to any one of the preceding claims, **characterized in that** the device comprises two guides extending parallel to each other and a beam extending transversely to said guides, which beam is movable over said guides, with a slide being movable over said beam, wherein means are provided for determining a first difference between the desired position and the actual position of the beam on the first guide, means are provided for determining a second difference between the desired position and the actual position of the beam on the second guide, means are provided for determining a position difference between the desired position and the actual position of a specific point on the beam on the basis of said first and second differences, means are provided for determining a variation between said first difference and said second difference on the basis of said first and second differences, and means are provided for determining the force and the torque to be exerted on the beam in dependence at least on said position difference, said variation and the position of the slide relative to the centre of mass of the beam, as well as means for exerting the force and the torque as determined on the beam.

EP 1 674 421 A2

FIG.1

FIG.2